# EUROPEAN PATENT SPECIFICATION

(11) **EP 3 281 232 B1**
(45) Date of publication and mention of the grant of the patent: **19.02.2020**
(21) Application number: 16714907.9
(22) Date of filing: 07.04.2016
(51) Int. Cl.: H01L 31/0224

(54) **A MATERIAL STRUCTURE FOR A SOLAR CELL, A SOLAR CELL AND A METHOD FOR MANUFACTURING A MATERIAL STRUCTURE**
MATERIALSTRUKTUR FÜR EINE SOLARZELLE, SOLARZELLE UND VERFAHREN ZUR HERSTELLUNG EINER MATERIALSTRUKTUR
STRUCTURE DE MATÉRIAU POUR CELLULE SOLAIRE, CELLULE SOLAIRE ET PROCÉDÉ DE FABRICATION D'UNE TELLE STRUCTURE

(30) Priority: 10.04.2015 EP 15163195
(43) Date of publication of application: 14.02.2018
(73) Proprietor: INL - International Iberian Nanotechnology Laboratory, 4715-330 Braga (PT)
(72) Inventor: SALOMÉ, Pedro, 4715-330 Braga (PT); SADEWASSER, Sascha, 4715-330 Braga (PT); MONTELIUS, Lars, 4715-330 Braga (PT)
(74) Representative: AWA Sweden AB
(86) International application number: PCT/EP2016/057586
(87) International publication number: WO 2016/162401

(56) References cited:
- US-A1- 2011 277 833
- US-A1- 2013 061 926
- US-A1- 2014 216 537
- US-A1- 2014 373 917

## Description

### Technical Field

The present invention relates to a material structure for a solar cell and a method for manufacturing the material structure. A solar cell comprising the material structure is also disclosed.

### Background Art

Solar cells convert solar energy into electrical energy. Cost effective large scale production of solar cells for efficient energy conversion is, however, challenging. A conventional solar cell comprises a light absorbing layer arranged to absorb photons and to convert the energy of the photons into free charge carriers which are separated such that a potential difference is achieved. The light absorbing layer typically forms part of a pn-junction of the solar cell. Hence, radiation of an appropriate wavelength falling on to the light absorbing layer may reach the pn-junction providing electron-hole pairs. A potential difference over the pn-junction is further obtained as holes and electrons move across the junction in opposite directions. An electric current may thereby be generated which may e.g. deliver electrical power to an external circuit.

A large cost when manufacturing a solar cell is the expensive materials used. To date, the market is dominated by solar cells based on crystalline silicon wafers onto which a light absorbing layer or layers comprising monocrystalline or multi-crystalline silicon is/are arranged. These solar cells have high conversion efficiencies, but are expensive to manufacture and are brittle.

There are, however, other semiconductor materials that have advantageous photovoltaic characteristics. Compounds such as Cu(In,Ga)Se₂, also referred to as CIGS, and CdTe may also be commercially used as light absorbing layers in solar cells. These compounds have higher absorption coefficients as compared to silicon. Therefore a lower thickness of the light absorbing layer is needed to collect the same amount of photons as compared to silicon based solar cells. Thinner and thereby more cost effective solar cells may hence be provided.

To access the electrical power generated by solar cells, electrodes are formed on the solar cells to extract charge carries from the pn-junction. The electrodes may be formed by metalizing portions of the front- and back-sides of the solar cells.

Although a back side metal contact may provide efficient contacting to the light absorbing layer it may capture charge carries generated within the light absorbing layer. The back side metal contact may additional capture light that has not been absorbed by the light absorbing layer.

To increase the efficiency of the solar cell a passivated emitter rear contact, PERC, structure may be used. The PERC structure comprises a passivation layer arranged in between the light absorbing layer and the metal contact. The passivation layer has openings through which the metal contact may be brought in electrical contact with the light absorbing layer. The passivation layer of the PERC structure may thereby acts as a spacer layer mitigating that charge carriers from within the light absorbing layer are captured by the metal layer. In other words, the passivation layer may mitigate electron and/or hole recombination at defects and other recombination sites that may occur at the interface between the light absorbing layer and the metal layer. The passivation layer may thereby assist in maintaining an electrical potential difference, across the light absorbing layer such that a solar cell with increased energy yield may be provided.

Hence, solar cells comprising PERC structures offer efficiency enhancement, but require extra processing steps for depositing and patterning of the passivation layer. This further increases the costs for manufacturing the solar cells.

US 2014/0373917 A1 discloses a photovoltaic device. The photovoltaic device includes a transparent layer. A first porous layer is disposed on the transparent layer, wherein the first porous layer comprises a plurality of pores extending through a thickness of the first porous layer. A first semiconductor material is then disposed in the plurality of pores to form a patterned first semiconductor layer. A second semiconductor layer is then disposed on the first porous layer and the patterned first semiconductor layer. The patterned first semiconductor layer is substantially transparent. A method of making a photovoltaic device is also disclosed.

US 2013/0061926 A1, discloses a solar cell element comprising a semiconductor substrate which has a p-type semiconductor region. One or more surface layer-internal regions which have Si-O bonds are formed in the surface layer part of the p-type semiconductor region. A passivation layer is formed on the surface layer-internal regions. A solar cell module comprising the solar cell element is also disclosed, so is a method for producing a solar cell element.

There is therefore a need to reduce material and manufacturing costs when manufacturing solar cells. There is also a need to increase the efficiency of the solar cells to lower the cost per watt produced. To this end, methods which could be adapted to low-cost, high-volume manufacturing of solar cells are desirable.

### Summary of the invention

It is an object of the present invention to provide an improvement of the above techniques and prior art.

According to an aspect of the invention, this is achieved by a material structure for a solar cell according to claim 1.

A material structure in which the electrical contacts are formed with a reduced amount of material is thereby provided. This reduces the cost of the material structure. It is advantageous that the electrical contacts are formed by a first metal and the metal layer is formed by a second metal, the second metal being different from the first metal. Hence, the electrical contacts and the metal layer may be formed by different materials or different combinations of materials which may be chosen independently of each other.

The material of the electrical contacts may therefore be chosen based on a first set of characteristics such as providing low resistivity, good adhesion, having low roughness, and being chemically inert to the material of the light absorbing layer and the passivation layer. The material of the metal layer may, however, be chosen based on a second set of characteristics allowing for a simplified manufacturing, a low resistivity, and providing an improved reflectivity as compared to the material of the electrical contacts. An increased portion of light may thus be reflected back into the light absorbing layer or out of the material structure, i.e. more light may be absorbed by the light absorbing layer. To this end, less light may be absorbed in the metal layer whereby the metal layer is heated to a lower extent which increases the performance of the material structure. The simplified manufacturing may reduce manufacturing costs as well as allowing for improved scalability of the manufacturing. Further, the cost for manufacturing the material structure may also be reduced.

The wording *passivation layer* should be construed as a layer arranged on at least a portion of the metal layer. The passivation layer thereby acts as a spacer layer mitigating that charge carriers from within the light absorbing layer are captured by the metal layer. The passivation layer reduces electron and/or hole recombination at the metal layer and/or at an interface between the metal layer and the light absorbing layer. In other words, the passivation layer assists in maintaining an electrical gradient, also referred to as a difference in charge or an electrical potential difference, across the light absorbing layer.

The electrical contacts comprises a metal. The electrical contacts thereby provide efficient transfer of charges.

The electrical contacts are formed by a first metal, wherein the electrical contacts comprises molybdenum, Mo. The use of Mo is beneficial as Mo offers low resistivity, good adhesion, has low surface roughness, and is essentially chemically inert to materials such as e.g. Cu, In, Ga, Zn, Sn, S and Se which may form parts of the light absorbing layer. Mo furthermore forms an ohmic contact with the light-absorbing layer and has a low diffusion coefficient. Mo is also stable during elevated temperatures which may for instance occur during the manufacturing of the material structure.

The passivation layer comprises a dielectric material and/or a semiconductor material. The amount of charges originating from the light absorbing layer that are lost due to recombination at the interface between the passivation layer and the light absorbing layer may thereby be reduced. The material structure may thereby reduce recombination losses resulting in an increased electrical performance. By selecting a specific dielectric material and/or a semiconductor material the passivation layer may further be tuned to reflect light within a desired energy range.

The metal layer is formed by a second metal, wherein the second metal is different from the first metal.

The metal layer may comprise Cu, Al, Ag, Mo, W, Cr, Ta, Nb, V, Ti, Mn, ZrN, TiN, Nb:TiO₂, TiB₂ or combinations thereof. The metal layer may thereby be brought in galvanic contact with the electrical contacts. Efficient contacting of the material structure is thereby provided. The metal layer may thereby further comprise a material which provides high reflectance in the visible spectrum of light.

The light absorbing layer is a compound semiconductor material consisting of Cu(In, Ga)Se₂, Cu(In, Ga)(S, Se)₂, Cu₂ZnSn(S, Se)₄, or CdTe.

These semiconductor materials are advantageous to use as efficient absorption of light may be achieved within the light absorbing layer when using these materials. Materials comprising Cu, In and Se may form a thin layer that provides high absorption of light to be absorbed in a micron or few microns of the materials. Ga further increases the spectral window for light absorption. The absorption energies of the light absorbing layer may match the solar spectrum. An improved efficiency for absorbing light is thereby obtained.

The material structure may further comprise a substrate, wherein the metal layer is arranged on the substrate. The substrate provides improved handling to the material structure. The metal layer may further allow for heat transfer from the metal layer such that heating of the material structure is mitigated. An improved thermal management of the material structure may thereby be provided.

The material structure may further comprise a buffer layer, the buffer layer and the light absorbing layer forming parts of a pn-junction arranged to convert light to an electric voltage. Efficient separation of charge carriers generated by the light absorbed by the material structure may thereby be obtained.

According to a second aspect of the invention a solar cell comprising the material structure is provided according to 6. A solar cell with improved efficiency may thereby be obtained. The manufacturing cost of the solar cell may further be reduced. Advantages of using the above disclosed material structure will for brevity not be disclosed again. The above mentioned features, when applicable apply to the solar cell and reference is made to the above. According to a third aspect a method for manufacturing a material structure for a solar cell is provided according to claim 7.

The method is advantageous in that a material structure may be manufactured cost effectively with high throughput and high resolution. Nano-imprint lithography, moreover, provides openings in the passivation layer that may have diameters in the range of tens to hundreds of nanometers wherein the electrical contacts may be formed. An efficient passivation layer is thereby provided which offers increased surface coverage such that electron and/or hole recombination at the metal layer and/or at an interface between the metal layer and the light absorbing layer may be reduced. The wording *template* should be understood as *a mould*, also referred to as a stamp having a pattern. The pattern is transferred to the imprint polymer by mechanical deformation of the imprint polymer by pressing the template into the imprint polymer. Subsequent processes such as etching of the passivation layer using the imprinted imprint polymer as an etch mask may be performed. The instrumentation and materials used for NIL may vary as is known to the skilled person in the art.

The height of the pattern of the template should preferably be larger than the thickness of imprint polymer such that the openings formed in the imprint polymer during the imprint process extend from a top surface to a bottom surface of the imprint polymer. The wording *extend from a top surface to a bottom surface* of the imprint polymer should be construed as that the openings essentially stretch out in distance through the imprint polymer. The skilled person in the art knows that a residual layer may, however, in practice be present in openings as a result of the imprint technique.

The wording *exposing at least a portion of the passivation layer* should be understood as substantially exposing the passivation layer in a desired surface area. The skilled person in the art realizes that the surface area may be a given area of the material structure or substantially the whole material structure.

The forming of the electrical contacts may comprise selective deposition of a metal. By the wording *selective deposition* should be understood that metal is deposited at given desired locations in the material structure, i.e. in the openings in the passivation layer and for instance not on the passivation layer itself. The metal may thereby be essentially arranged only in the openings of the passivation layer. Selective deposition may be performed by different techniques such as electroplating and ink-jet printing.

The step of removing the imprinted imprint polymer may be performed prior to the step of forming of the electrical contacts.

This is advantageous as the risk is reduced that a material used for forming the electrical contacts sticks to the imprinted imprint polymer. Problems associated with the imprinted imprint polymer being bound to the material structure are thereby mitigated. Furthermore, the amount of material used for forming the electrical contacts may be reduced. A more efficient process for removing the imprinted imprint polymer is thereby obtained.

The forming of the electrical contacts may comprise sputtering and/or evaporation of a metal. A simple, cost effective and reliable method for providing electrical contacts of metals may thereby be used.

The step of removing the imprinted imprint polymer may be performed using a lift-off process.

The wording *lift-off* may be understood as a process of forming structures or patterns on a material surface of, e.g. the passivation layer by using a sacrificial layer, e.g. a layer of imprint polymer. In general, a pattern is formed in the sacrificial layer arranged on the material surface. By etching through the sacrificial layer openings are formed in the sacrificial layer exposing portions of the material surface. A target material may in a subsequent process be deposited, through the openings, on the material surface such that a final pattern may be created at those locations. The target material is typically deposited over the whole area of the sacrificial layer, reaching the material surface in the etched openings but also on top of the sacrificial layer where it has not been etched. The sacrificial layer may then be washed away such that the target material on the top of the sacrificial layer is lifted-off and washed away together with the sacrificial layer below. After the lift-off, the target material remains in the regions where it had a direct contact with the material surface.

The method may further comprise depositing a light absorbing layer on the passivation layer, the light absorbing layer being in galvanic contact with the electrical contacts. As a result a material structure is obtained which is suitable for absorbing light. The electrical contacts are further arranged to collect charge carriers generated within the light absorbing layer.

The method may further comprise depositing a buffer layer on the light absorbing layer, the buffer layer and the light absorbing layer forming parts of a pn-junction arranged to convert light to an electric voltage. Efficient separation of charge carriers generated by the light absorbed by the material structure may thereby be obtained. A material structure for a solar cell which is arranged to absorb light and convert optical energy into electrical energy is thereby achieved.

### Brief description of the drawings

This and other aspects of the present invention will now be described in more detail, with reference to the enclosed drawings showing embodiments.
Figure 1 illustrates a material structure according to one embodiment.
Figure 2 illustrates a method for manufacturing a material structure according to one embodiment.
Figure 3 illustrates pre-stages of and a material structure according to one embodiment.
Figure 4 illustrates pre-stages of and a material structure according to another embodiment.
Figure 5 illustrates pre-stages of and a material structure according to yet another embodiment.
Figure 6 illustrates a solar cell according to one embodiment.

### Detailed description

The present invention will now be described more fully hereinafter with reference to the accompanying drawings, in which currently preferred embodiments are shown. These embodiments are rather provided for thoroughness and completeness, and for fully conveying the scope to the skilled person.

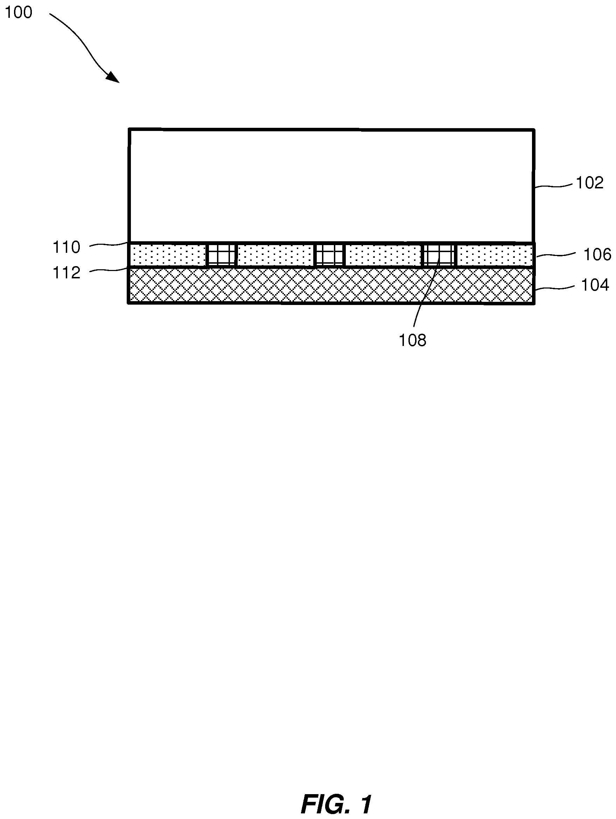

In the following a material structure for a solar cell and a method for manufacturing the material structure will be discussed with reference to figures 1 - 3. Figure 1 illustrates a material structure for a solar cell. The material structure 100 comprises a light absorbing layer 102, a metal layer 104 and a passivation layer 106. The passivation layer 106 is arranged in between the light absorbing layer 102 and the metal layer 104. A plurality of electrical contacts 108 are arranged within the passivation layer 106. The electrical contacts 108 extend from a top surface 110 to a bottom surface 112 of the passivation layer 106. The electrical contacts 108 are thereby in galvanic contact with the light absorbing layer 102 and the metal layer 104 allowing electrical currents to flow between the layers 102 and 104.

The electrical contacts 108 are formed by a first metal. The metal layer 104 is formed by a second metal, wherein the second metal is different from the first metal.

The material of the electrical contacts 108 may therefore be chosen based on a first set of characteristics such as providing low resistivity, good adhesion, having low roughness, and being chemically inert to the material of the light absorbing layer and the passivation layer. The material of the metal layer 104 may, however, be chosen based on a second set of characteristics allowing for a simplified manufacturing, a low resistivity, and providing an improved reflectivity as compared to the material of the electrical contacts.

To this end, the electrical contacts 108 comprise molybdenum, Mo.

The metal layer 104 comprises copper, Cu. The passivation layer 106 comprises Al₂O₃. The use of Al₂O₃ allows for an isolating passivation layer 106 having a large concentration of fixed charges, which may be deposited conformally on top of the metal layer 104. The light absorbing layer 102 comprises Cu(In, Ga)Se₂, also referred to as CIGS. The CIGS light absorbing layer 102 has a higher absorption coefficient than silicon and therefore a lower thickness of the light absorbing layer is needed to collect the same amount of photons as compared to silicon based solar cells.

The Mo electrical contacts 108 offer low resistivity, good adhesion to the light absorbing layer 102. Mo is moreover essentially chemically inert to the materials Cu, In, Ga, and Se of the CIGS material, even at elevated temperatures such as a CIGS high-temperature selenization process at which the temperature may be above 500°C. It may be noted that at such temperatures a thin MoSe₂ layer may be formed on the Mo electrical contacts 108 which further improves the conducting properties of the electrical contacts 108. Mo furthermore allows for the formation of ohmic contacts to the light-absorbing layer 102. Mo also has a low diffusion coefficient which makes the material stable even at elevated temperatures. Elevated temperatures may for instance occur during the manufacturing of the material structure 100. The performance of the material structure 100 may thereby be improved.

From the above it follows that it is favourable that the materials forming the electrical contacts 108 and the metal layer 104 are different such that their respective functions may be optimized. As a result a material structure 100 for a solar cell with an increased efficiency may be obtained. A metal layer 104 comprising for instance Cu provides high reflectance in the visible spectrum such that light may be reflected into the light absorbing layer.

The increased reflectivity provided by Cu metal layer 104 increase the amount of light on the material structure 100 that may be absorbed by the light absorbing layer 102. The thickness of the light absorbing layer 102 may thereby be reduced and thinner and more cost effective solar cells may be provided with respect to solar cells not comprising the material structure 100.

Cu also allows for cost effective manufacturing of the material structure 100 as compared to the metal layer comprising Mo. In other words, a material structure 100 comprising a lower amount of Mo may thereby be obtained. The costs associated with material forming the material structure 100 may thereby be reduced.

A metal layer 104 comprising Cu further offers improved performance of the material structure 100. The Cu layer 104 provides increased thermal conductivity and an increased electrical conductivity.

It should be noted that the electrical contacts 108 may be formed by molybdenum, Mo and the metal may 104 may be formed by Cu.

The Al₂O₃ passivation layer 106 increases the efficiency of the material structure in that it may reduce losses due to recombination.

The Al₂O₃ passivation layer 106 further acts as a spacer layer between the light absorbing layer 102 and the metal layer 104 in that it alleviates that charge carriers, generated by light absorption in the light absorbing layer 102, are captured by the metal layer 104. The Al₂O₃ passivation layer may thereby reduce electron and/or hole recombination at the interface between the metal layer 104 and the light absorbing layer 102. An improved electrical gradient across the light absorbing layer 102 may thereby be achieved resulting in that a higher electrical potential is generated. A more efficient conversion of optical energy to electrical energy may thereby be achieved by the material structure 100.

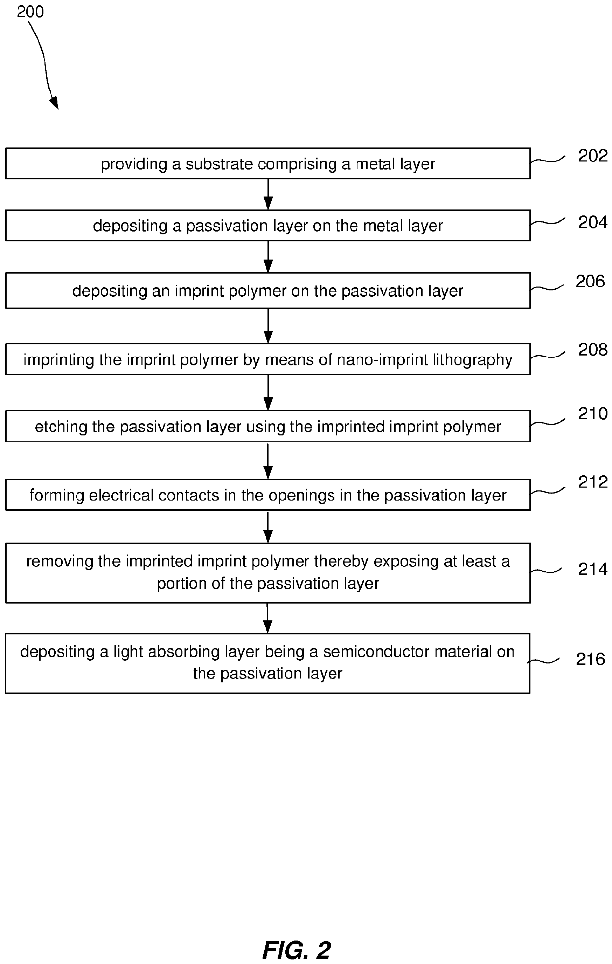

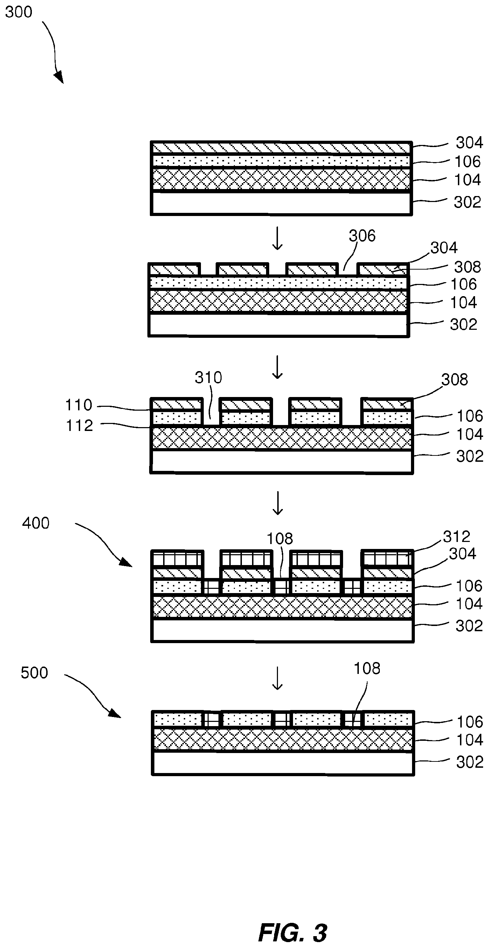

Next a method 200 for manufacturing the material structure 100 will be described with reference to figures 2 and 3. Figure 2 illustrates method steps whereas figure 3 illustrates pre-stages 300 of the material structure and material structure 100 achieved by performing the method 200.

The method 200 comprises the steps of providing 202 a substrate 302 onto which a metal layer 104 has been formed. The substrate comprises soda-lime glass, but the skilled person realizes that other substrates may be used as will be described below.

A passivation layer 106 is thereafter deposited 204 on the metal layer 104, followed by deposition 206 of an imprint polymer 304 on the passivation layer 106. The deposition 204 may be performed by atomic layer deposition, ALD. The deposition 206 may be performed by standard techniques such as spin-coating also referred to as spin-casting.

Nano-imprint lithography, NIL, is used to form a pattern in the passivation layer 106. In NIL the imprint polymer 304 is imprinted 208 using a template, also referred to as mold or stamp. The template comprises patterns, for example nanostructured patterns, which are transferred to the imprint polymer 304 when the template is pressed into the imprint polymer 304. In other words, the pressing of the template into the imprint polymer 304 creates an inverse pattern of the template resulting in that the imprint polymer 304 has a varying thickness.

The template may for example comprise silicon dioxide or silicon. Other materials such as metals and ceramics may also be used for the template. The template may for instance be patterned using electron beam lithography and reactive ion etching, RIE.

The template is removed after the imprint polymer has been imprinted, i.e. after the pattern of the template has been transferred into the imprint polymer 304. An anisotropic etching process, such as reactive ion etching, RIE, may further be used to remove residuals of the imprint polymer 304 in the area forming openings, i.e. the compressed area. During the imprint step, the imprint polymer 304 may be heated to a temperature above its glass transition temperature. The imprint polymer 304 may be a thermoplastic or thermosetting polymer which becomes a viscous liquid which can flow when heated, and therefore, be readily deformed when imprinted with the template. Generally, the imprint polymer 304 is cooled such that the imprint polymer 304 solidifies before the template is removed. A more effective transfer of the pattern of the template into the imprinted imprint polymer 304 may thereby be obtained.

Openings 306 in the imprint polymer 304 are thereby formed by the imprint process.

It should be noted that the resolution of NIL, unlike conventional lithography methods such as electron beam lithography and optical lithography using energetic beams, is not limited by the effects of wave diffraction, scattering and interference in a resist, i.e. the imprint polymer, and backscattering from the substrate. An improved resolution for manufacturing features on the nanoscale may thereby be obtained. Beam scanning is moreover not needed in NIL which improves the speed for manufacturing the material structure. Hence, NIL offers high-resolution high-throughput lithography which may be used for low-cost mass production of nanostructures over large areas.

Next, the passivation layer 106 may be etched 210 using the imprinted imprint polymer 304 as an etch mask 308 such that openings 310 are formed in the passivation layer 106. The openings 310 extend from a top surface 110 to a bottom surface 112 of the passivation layer 106. The etching may be performed using reactive ion etching.

After the openings 310 in the passivation layer 106 have been provided electrical contacts 108 may be formed 212 in the openings 310. The electrical contacts 108 may be formed by different processes as will be described below. The electrical contacts 108 should, however, be in galvanic contact with the metal layer 104.

The imprinted imprint polymer 304 may then be removed 214 thereby exposing at least a portion of the passivation layer 106. The imprinted imprint polymer 304 may be removed by a standard heated polymer "remover". Typically an ultrasonic bath is used during the removal together with an organic element such as acetone or a commercially available polymer remover. Techniques such as O₂-plasma treatment may further be used for the removing 214.

The electrical contacts 108 may be formed 212 using sputtering and/or evaporation of a metal as illustrated by the pre-stage 400 of the material structure shown in figure 3. Methods for depositing materials such as metals are known in the field of the art and will not be discussed further. Sputtering and/or evaporation of the metal, before the imprinted imprint polymer 304 is removed 214, results in that metal 312 may be deposited on at least a portion of the imprinted imprint polymer 304. The electrical contacts 108 extend preferably through the passivation layer 106.

The removing 214 of the imprinted imprint polymer may be performed using a lift-off process. The lift-off of the imprinted polymer layer may be performed by soaking the substrate in acetone or a remover in an ultrasonic bath. The imprinted imprint polymer 106 and the metal 312 may thereby be efficiently removed by the lift-off. The resulting pre-stage 500 of the material structure is shown in figure 3. Methods and recipes for lift-off is known to a skilled person in the art and reference may for example be given to Carlberg et al, "Lift off process for nanoimprint lithography", Microelectronic Engineering 67-68, p 203 (2003).

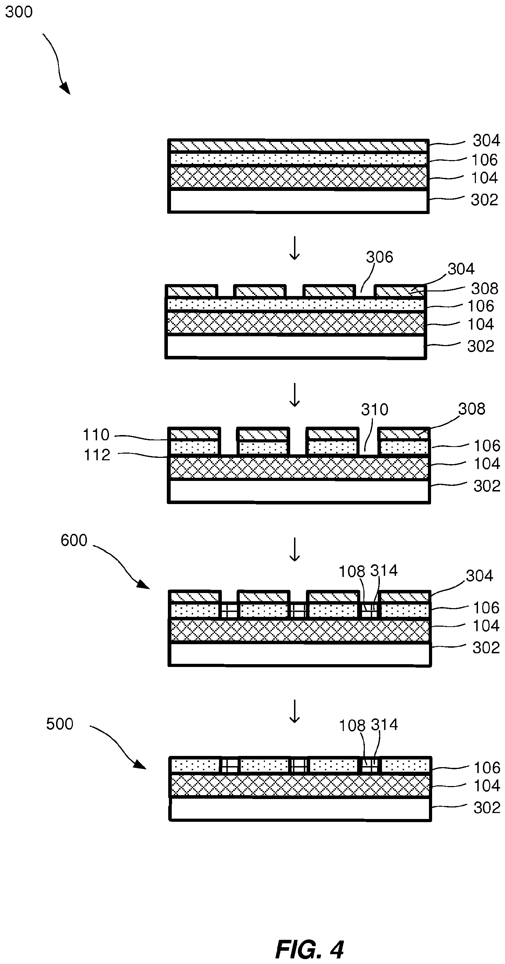

Now referring to figure 4, the forming of the electrical contacts 108 may comprise selective deposition of a metal 314. The metal 314 may thereby be formed essentially only in the openings 310 of the passivation layer 106, as illustrated by the pre-stage 600 of the material structure. The selective deposition of a metal 314 may be achieved by electroplating. Electroplating is a well-known technique within the field of nanoprocessing which may take advantage of the imprint polymer 106 being an insulator such that the metal is deposited primarily on surfaces of the metal layer 104 that are exposed in the openings 310. The electrical contacts 108 extend through the passivation layer 106.

The imprinted imprint polymer 304 may then be removed 214 as described above, thereby exposing at least a portion of the passivation layer 106.

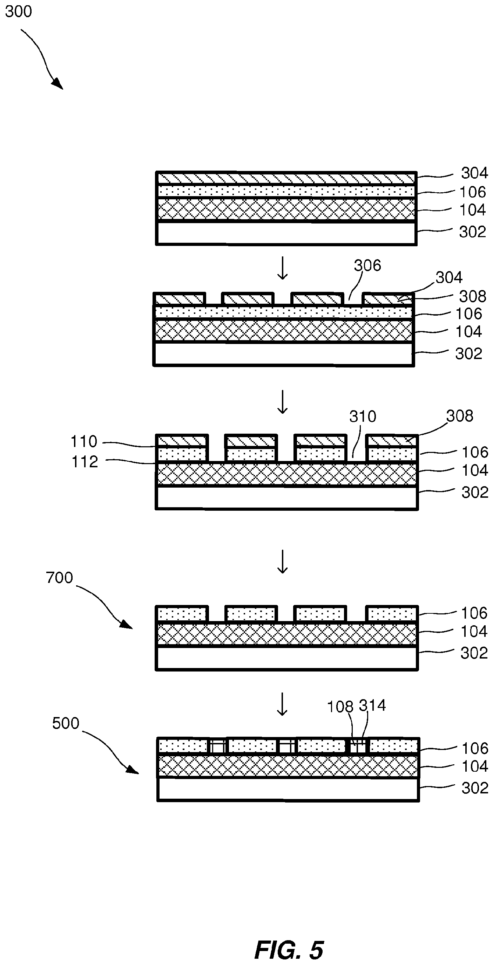

Now referring to figure 5, the removing 214 of the imprinted imprint polymer 106 may alternatively be performed prior to the step of forming 212 of the electrical contacts 108, which results in that the pre-stage 700 of the material structure is obtained.

The electrical contacts 108 may thereafter be formed as described above by selective deposition such that the pre-stage 500 of the material structure is formed.

The imprint polymer 106 may comprise polymethyl methacrylate, PMMA. PMMA has a small and advantageous thermal expansion coefficient and a small pressure shrinkage coefficient. Template release agents may further be added into the imprint polymer to reduce adhesion to the template. Also to template may be anti-sticking treated to facilitate its removal from the imprint polymer.

The skilled person in the art realises that UV-curable imprint polymers may be used when fabricating the material structure. In this case an irreversible cross-linked imprint polymer is used.

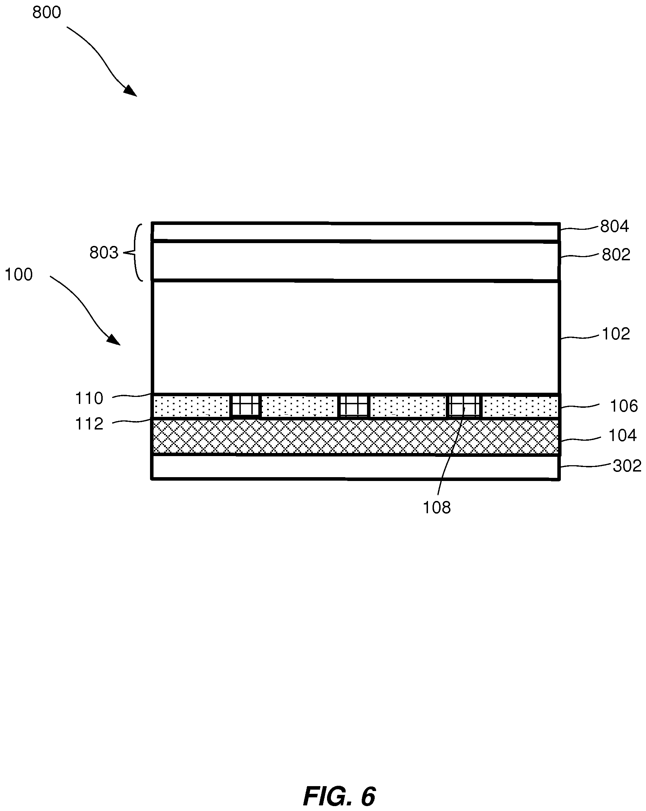

The method 200 may further comprise depositing a light absorbing layer 102 on the passivation layer 106 whereby the material structure 100 is obtained on a substrate 302, see figure 6. The light absorbing layer 102 may be brought in galvanic contact with the metal layer 104, via the electrical contacts 108, as a result of the electrical contacts 108 extending thought the passivation layer 106.

The method 200 may further comprise depositing a buffer layer 802 on the light absorbing layer 102 as is illustrated in figure 6, where a solar cell 800 comprising the material structure 100 is arranged on a substrate 302. The light absorbing layer 102 is composed of CIGS which is p-type. The buffer layer 802 comprises a CdS material which is n-type. The light absorbing layer 102 and the buffer layer 802 thereby form parts of a pn-junction arranged to convert light to an electric voltage. The buffer layer 802 may further form part of a stack of layers 803 as illustrated in figure 6. The stack of layers 803 may comprise a transparent conducting layer 804 arranged on top of the buffer layer 802. The transparent conducting layer 804 comprises in the depicted embodiment a i-ZnO/ZnO:Al material, i.e. a thin, intrinsic zinc oxide layer (i-ZnO) which is capped by a thicker, aluminium, Al, doped ZnO layer. The i-ZnO layer is used to protect the CdS buffer layer 802 and the light absorbing layer 102 from sputtering damage while depositing the ZnO:Al layer. The Al doped ZnO serves as a transparent conducting oxide to collect and move electrons out of the solar cell 800 while absorbing as little light as possible.

The solar cell 800 comprises a heterostructure junction formed between the CIGS light absorbing layer 102 and the transparent conducting layer 804 of ZnO, which are separated by the thin buffer layer 802 of CdS and a layer of intrinsic ZnO. The CIGS light absorbing layer 102 is doped p-type by intrinsic defects, while the ZnO transparent conducting layer 804 is doped n-type to a much larger extent through the incorporation of Al. This asymmetric doping provides a space-charge region extend to a larger extent into the CIGS than into the ZnO. The absorption of light is thereby designed to predominately occur in the light absorbing layer 102. To this end, the thicknesses and band gaps of the light absorbing layer 102, the buffer layer 802, and the transparent conducting layer 804 are chosen such that the light is absorbed predominately in the light absorbing layer 102. The band gap of the CIGS light absorbing layer 102 ranges typically between 1.02 eV for CuInSe₂ to 1.65 eV for CuGaSe₂ providing increased light absorption, while the larger band gaps for ZnO of 3.2 eV and CdS of 2.4 eV minimizes light absorption in the upper layers 802 and 804. The doped ZnO also serves as front contact for current collection.

The metal layer 104 comprises Cu, typically 0.5 - 5 µm thick onto which the passivation layer 106 has been deposited to decrease charge recombination at the interface of the metal layer 104 and increase internal reflection. The passivation layer 106 comprises Al₂O₃ deposited by means of atomic layer deposition, ALD, on to the metal layer 104. The passivation layer 106 further comprises electrical contacts 108 of Mo which may be formed as described above.

The substrate 302 comprises soda lime glass as a substrate and contains sodium, which has been shown to yield a substantial open-circuit voltage increase through surface and/or grain boundary defects passivation. The substrate may have a thickness of 1-3 mm.

The CdS buffer layer may be deposited using a standard chemical bath deposition, CBD, process. The transparent conducting layer 804 may be formed using shunt reducing intrinsic ZnO layer, i-ZnO, and subsequently sputtering of Al-doped ZnO, ZnO:AI.

The stack of layers 803 may further comprise anti-reflective coating, not shown, which may be formed by evaporation to improve light absorption of the solar cell, mainly by avoiding interference effects.

A front contact grid comprising a Ni/Al/Ni stack, not shown, may further be deposited by evaporation.

The buffer layer may alternatively comprise a material selected from a group consisting of Zn₁₋ₓSnₓO_{y}, In₂S₃, Zn(S,O,OH), Zn(S,O), InSₓO_{y}, ZnS, ZnS:In₂S₃, InₓS_{y}.

The transparent conductive layer may, moreover, comprise a material selected from a group consisting of Ga-doped ZnO, SnO₂:In₂O₃,SnO₂:F, CdO:ln, graphene, and carbon nano-tubes.

According to the above description the metal layer 104 has been disclosed as comprising Cu. In other embodiments the metal layer may comprise Al, Ag, Mo, W, Cr, Ta, Nb, V, Ti, Mn, ZrN, TiN, Nb:TiO₂, TiB₂ or combinations thereof.

The passivation layer 106 has been described as to comprise Al₂O₃. According to other embodiments the passivation layer may be selected from a group consisting of dielectric materials such as Al₂O3, SiO₂, Al₂N₃, Si₃N₄, AION, TiO₂, HfO₂.

Alternatively the passivation layer may comprise a semiconductor material such as ZnO, InS, In₂O₃, BeO, AlN, BN, GaP.

The light absorbing layer may further comprise a compound semiconductor material consisting of Cu(In, Ga)(S, Se)₂, Cu₂ZnSn(S, Se)₄, or CdTe.

The person skilled in the art further realizes that the present invention by no means is limited to the preferred embodiments described above. On the contrary, many modifications and variations are possible within the scope of the appended claims. For example, the substrate may be a glass material such as alkali-aluminosilicate glass or boro-silicate glass. The substrate may alternatively comprise a metal foil, a ceramic substrate, or a plastic substrate.

The light absorbing layer may alternatively be a compound semiconductor material comprising a plurality of other elements from the periodic table. The light absorbing layer may be of a group IV element such as Si, amorphous Si, nanocrystalline silicon or micromorphous silicon.

The light absorbing layer may comprise a III-V or a II-VI semiconductor material. Hence the light absorbing layer may in some embodiments for example comprise GaAs, and InP. The light absorbing layer may be of a material having a perovskite crystal structure.

The substrate may form the metal layer.

The light absorbing layer may be formed form by a chalcopyrite or a kesterite material. For such materials the substrate may be a sheet of glass or foil. The glass substrate may for example have a dimension of 80 cm x 120 cm. The foil may typically be arranged in a roll of a specific width, which may be 1 m in extension.

It should further be noted that the method described above may be used to provide electrical contacts and a metal layer comprising the same material compositions or different materials compositions. Hence a versatile method is provided.

Additionally, variations to the disclosed embodiments can be understood and effected by the skilled person, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A material structure for a solar cell, the material structure (100) comprising,
a light absorbing layer (102) being a a compound semiconductor material consisting of Cu(In, Ga)Se₂, Cu(In, Ga)(S, Se)₂, Cu₂ZnSn(S, Se)₄, or CdTe,
a light reflecting metal layer (104),
a passivation layer (106) comprising a dielectric material and/or a semiconductor material, the passivation layer (106) being arranged in between the light absorbing layer (102) and the light reflecting metal layer (104), the passivation layer (106) comprising a plurality of electrical contacts (108) comprising molybdenum, Mo, the electrical contacts (108) extending from a top surface (110) to a bottom surface (112) of the passivation layer (106) such that the electrical contacts (108) are in galvanic contact with the light absorbing layer (102) and the light reflecting metal layer (104), wherein the electrical contacts (108) are formed by a first metal and the light reflecting metal layer (104) is formed by a second metal, the second metal being different from the first metal, the second metal having an improved reflectivity as compared to the first metal, wherein the light reflecting layer (104) is arranged to reflect light back into the light absorbing layer (102).

2. The material structure according to claim 1, wherein the light reflecting metal layer (104) comprises Cu, Al, Ag, Mo, W, Cr, Ta, Nb, V, Ti, Mn, ZrN, TiN, Nb:TiO₂, TiB₂ or combinations thereof.

3. The material structure according to any one of claims 1 - 2, further comprising a substrate (302), wherein the metal layer (104) is arranged on the substrate (302).

4. The material structure according to any one of claims 1 - 3, further comprising a buffer layer (802), the buffer layer (802) and the light absorbing layer (102) forming parts of a pn-junction arranged to convert light to an electric voltage.

5. A solar cell comprising a material structure according to any one of claims 1 - 4.

6. A method for manufacturing a material structure for a solar cell, the method (200) comprising the steps of
providing (202) a substrate (302) comprising a metal layer (104),
depositing (204) a passivation layer (106) on the metal layer (104), the passivation layer (106) comprising a dielectric material and/or a semiconductor material,
depositing (206) an imprint polymer (304) on the passivation layer (106),
imprinting (208) the imprint polymer (304) by means of nano-imprint lithography, NIL, using a template, thereby forming openings (306) in the imprint polymer (304) extending from a top surface to a bottom surface thereof,
etching (210) the passivation layer (106) using the imprinted imprint polymer (304) as an etch mask thereby forming openings (310) in the passivation layer (106) extending from a top surface (110) to a bottom surface (112) thereof,
forming (212) electrical contacts (108) in the openings (310) in the passivation layer (106), the electrical contacts (108) comprising molybdenum, Mo and being in galvanic contact with the metal layer (104),
removing (214) the imprinted imprint polymer (304) thereby exposing at least a portion of the passivation layer (106),
depositing (216) a light absorbing layer (102) being a compound semiconductor material consisting of Cu(ln, Ga)Se₂, Cu(ln, Ga)(S, Se)₂, Cu₂ZnSn(S, Se)₄, or CdTe on the passivation layer (106), the light absorbing layer (102) being in galvanic contact with the electrical contacts (108),
wherein the electrical contacts (108) are formed by a first metal and the metal layer (104) is formed by a second metal, the second metal being different from the first metal, wherein the second metal has an improved reflectivity as compared to the first metal.

7. The method according to claim 6, wherein the forming (212) of the electrical contacts (108) comprises selective deposition of a metal (314).

8. The method according to claim 6, wherein the step of removing (214) the imprinted imprint polymer (304) is performed prior to the step of forming (212) of the electrical contacts (108).

9. The method according to claim 6, wherein the forming (212) of the electrical contacts (108) comprises sputtering and/or evaporation of a metal.

10. The method according to claim 9, wherein the step of removing (214) the imprinted imprint polymer (304) is performed using a lift-off process.

11. The method according to claim 6, the method (200) further comprising depositing a buffer layer (802) on the light absorbing layer (102), the buffer layer (802) and the light absorbing layer (102) forming parts of a pn-junction arranged to convert light to an electric voltage.

## Patentansprüche

1. Materialstruktur für eine Solarzelle, wobei die Materialstruktur (100) umfasst:
eine lichtabsorbierende Schicht (102), bei der es sich um ein Verbindungshalbleiter-Material handelt, das aus Cu(ln, Ga)Se₂, Cu(ln, Ga)(S, Se)₂, Cu₂ZnSn(S, Se)₄ oder CdTe besteht,
eine lichtreflektierende Metallschicht (104),
eine Passivierungsschicht (106), die ein dielektrisches Material und/oder ein Halbleitermaterial umfasst, wobei die Passivierungsschicht (106) zwischen der lichtabsorbierenden Schicht (102) und der lichtreflektierenden Metallschicht (104) angeordnet ist, die Passivierungsschicht (106) mehrere elektrische Kontakte (108) umfasst, die Molybdän, Mo, umfassen, die elektrischen Kontakte (108) sich derart von einer Oberseitenfläche (110) zu einer Unterseitenfläche (112) der Passivierungsschicht (106) erstrecken, dass die elektrischen Kontakte (108) in galvanischem Kontakt mit der lichtabsorbierenden Schicht (102) und der lichtreflektierenden Metallschicht (104) stehen, wobei
die elektrischen Kontakte (108) durch ein erstes Metall ausgebildet werden und die lichtreflektierende Metallschicht (104) durch ein zweites Metall ausgebildet wird, wobei das zweite Metall von dem ersten Metall verschieden ist, das zweite Metall - verglichen mit dem ersten Metall - ein verbessertes Reflexionsvermögen aufweist, wobei die lichtreflektierende Schicht (104) dazu angeordnet ist, Licht zurück in die lichtabsorbierende Schicht (102) zu reflektieren.

2. Materialstruktur nach Anspruch 1, wobei die lichtreflektierende Metallschicht (104) Cu, Al, Ag, Mo, W, Cr, Ta, Nb, V, Ti, Mn, ZrN, TiN, Nb:TiO₂, TiB₂ oder Kombinationen derselben umfasst.

3. Materialstruktur nach einem der Ansprüche 1 bis 2, die ferner ein Substrat (302) umfasst, wobei die Metallschicht (104) auf dem Substrat (302) angeordnet ist.

4. Materialstruktur nach einem der Ansprüche 1 bis 3, die ferner eine Pufferschicht (802) umfasst, wobei die Pufferschicht (802) und die lichtabsorbierende Schicht (102) Teile eines pn-Übergangs sind, der dazu angeordnet ist, Licht in eine elektrische Spannung umzuwandeln.

5. Solarzelle, die eine Materialstruktur nach einem der Ansprüche 1 bis 4 umfasst.

6. Verfahren zur Herstellung einer Materialstruktur für eine Solarzelle, wobei das Verfahren (200) folgende Schritte umfasst:
Bereitstellen (202) eines Substrats (302), das eine Metallschicht (104) umfasst,
Abscheiden (204) einer Passivierungsschicht (106) auf der Metallschicht (104), wobei die Passivierungsschicht (106) ein dielektrisches Material und/oder ein Halbleitermaterial umfasst,
Abscheiden (206) eines Druckpolymers (304) auf der Passivierungsschicht (106),
Drucken (208) des Druckpolymers (304) mittels Nanodrucklithographie, NIL, unter Benutzung einer Schablone und dadurch Ausbilden von Öffnungen (306) in dem Druckpolymer (304), die sich von einer Oberseitenfläche zu einer Unterseitenfläche desselben erstrecken, Ätzen (210) der Passivierungsschicht (106) unter Benutzung des gedruckten Druckpolymers (304) als Ätzmaske und dadurch Ausbilden von Öffnungen (310) in der Passivierungsschicht (106), die sich von einer Oberseitenfläche (110) zu einer Unterseitenfläche (112) desselben erstrecken,
Ausbilden (212) elektrischer Kontakte (108) in den Öffnungen (310) in der Passivierungsschicht (106), wobei die elektrischen Kontakte (108) Molybdän, Mo, umfassen und in galvanischem Kontakt mit der Metallschicht (104) stehen,
Entfernen (214) des gedruckten Druckpolymers (304) und dadurch Freilegen wenigstens eines Abschnitts der Passivierungsschicht (106),
Abscheiden (216) einer lichtabsorbierenden Schicht (102), bei der es sich um ein Verbindungshalbleiter-Material handelt, das aus Cu(ln, Ga)Se₂, Cu(ln, Ga)(S, Se)₂, Cu₂ZnSn(S, Se)₄ oder CdTe besteht, auf der Passivierungsschicht (106), wobei die lichtabsorbierende Schicht (102) in galvanischem Kontakt mit den elektrischen Kontakten (108) steht,
wobei die elektrischen Kontakte (108) durch ein erstes Metall ausgebildet werden und die Metallschicht (104) durch ein zweites Metall ausgebildet wird, wobei das zweite Metall von dem ersten Metall verschieden ist, wobei das zweite Metall - verglichen mit dem ersten Metall - ein verbessertes Reflexionsvermögen aufweist.

7. Verfahren nach Anspruch 6, wobei das Ausbilden (212) der elektrischen Kontakte (108) eine selektive Abscheidung eines Metalls (314) umfasst.

8. Verfahren nach Anspruch 6, wobei der Schritt des Entfernens (214) des gedruckten Druckpolymers (304) vor dem Schritt des Ausbildens (212) der elektrischen Kontakte (108) erfolgt.

9. Verfahren nach Anspruch 6, wobei das Ausbilden (212) der elektrischen Kontakte (108) ein Sputtern und/oder Verdampfen eines Metalls umfasst.

10. Verfahren nach Anspruch 9, wobei der Schritt des Entfernens (214) des gedruckten Druckpolymers (304) mittels eines Lift-off-Prozesses erfolgt.

11. Verfahren nach Anspruch 6, wobei das Verfahren (200) ferner ein Abscheiden einer Pufferschicht (802) auf der lichtabsorbierenden Schicht (102) umfasst, wobei die Pufferschicht (802) und die lichtabsorbierende Schicht (102) Teile eines pn-Übergangs sind, der dazu angeordnet ist, Licht in eine elektrische Spannung umzuwandeln.

## Revendications

1. Structure de matériau pour cellule solaire, la structure de matériau (100) comprenant,
une couche d'absorption de lumière (102) qui est un matériau de composé semiconducteur constitué de Cu(In, Ga)Se₂, Cu(In, Ga)(S, Se)₂, Cu₂ZnSn(S, Se)₄ ou CdTe,
une couche de métal réfléchissant la lumière (104),
une couche de passivation (106) comprenant un matériau diélectrique et/ou un matériau semiconducteur, la couche de passivation (106) étant disposée entre la couche d'absorption de lumière (102) et la couche de métal réfléchissant la lumière (104), la couche de passivation (106) comprenant une pluralité de contacts électriques (108) comprenant du molybdène, Mo, les contacts électriques (108) s'étendant d'une surface de partie supérieure (110) à une surface de partie inférieure (112) de la couche de passivation (106) de telle manière que les contacts électriques (108) sont en contact galvanique avec la couche absorbant la lumière (102) et la couche de métal réfléchissant la lumière (104),
où les contacts électriques (108) sont formés par un premier métal et la couche de métal réfléchissant la lumière (104) est formée par un second métal, le second métal étant différent du premier métal, le second métal ayant une réflectivité améliorée par rapport au premier métal, où la couche réfléchissant la lumière (104) est disposée pour réfléchir la lumière dans la couche d'absorption de lumière (102).

2. Structure de matériau selon la revendication 1, dans laquelle la couche de métal réfléchissant la lumière (104) comprend Cu, Al, Ag, Mo, W, Cr, Ta, Nb, V, Ti, Mn, ZrN, TiN, Nb : TiO₂, TiB₂ ou leurs combinaisons.

3. Structure de matériau selon l'une quelconque des revendications 1 à 2, comprenant en outre un substrat (302), où la couche de métal (104) est disposée sur le substrat (302).

4. Structure de matériau selon l'une quelconque des revendications 1 à 3, comprenant en outre une couche tampon (802), la couche tampon (802) et la couche absorbant la lumière (102) formant des parties d'une jonction pn disposée pour convertir la lumière en tension électrique.

5. Cellule solaire comprenant une structure de matériau selon l'une quelconque des revendications 1 à 4.

6. Procédé de fabrication d'une structure de matériau pour cellule solaire, le procédé (200) comprenant les étapes consistant à
fournir (202) un substrat (302) comprenant une couche de métal (104),
déposer (204) une couche de passivation (106) sur la couche de métal (104), la couche de passivation (106) comprenant un matériau diélectrique et/ou un matériau semiconducteur,
déposer (206) un polymère d'impression (304) sur la couche de passivation (106),
imprimer (208) le polymère d'impression (304) au moyen d'une lithographie de nano-impression, en utilisant une matrice, formant ainsi des ouvertures (306) dans le polymère d'impression (304) s'étendant d'une de ses surfaces de partie supérieure à une de ses surfaces de partie inférieure,
graver (210) la couche de passivation (106) en utilisant le polymère d'impression imprimé (304) comme masque de gravure formant ainsi des ouvertures (310) dans la couche de passivation (106), s'étendant d'une de ses surfaces de partie supérieure (110) à une de ses surfaces de partie inférieure (112),
former (212) des contacts électriques (108) dans les ouvertures (310) dans la couche de passivation (106), les contacts électriques (108) comprenant du molybdène, Mo et étant en contact galvanique avec la couche de métal (104),
enlever (214) le polymère d'impression imprimé (304) exposant ainsi au moins une partie de la couche de passivation (106),
déposer (216) une couche d'absorption de lumière (102) qui est un matériau de composé semiconducteur constitué de Cu(ln, Ga)Se₂, Cu(ln, Ga)(S, Se)₂, Cu₂ZnSn(S, Se)₄ ou CdTe sur la couche de passivation (106), la couche absorbant la lumière (102) étant en contact galvanique avec les contacts électriques (108),
où les contacts électriques (108) sont formés par un premier métal et la couche de métal (104) est formée par un second métal, le second métal étant différent du premier métal, où le second métal a une réflectivité améliorée par rapport au premier métal.

7. Procédé selon la revendication 6, dans lequel la formation (212) des contacts électriques (108) comprend le dépôt sélectif d'un métal (314).

8. Procédé selon la revendication 6, dans lequel l'étape d'enlèvement (214) du polymère d'impression imprimé (304) est effectuée avant l'étape de formation (212) des contacts électriques (108).

9. Procédé selon la revendication 6, dans lequel la formation (212) des contacts électriques (108) comprend la pulvérisation et/ou l'évaporation d'un métal.

10. Procédé selon la revendication 9, dans lequel l'étape d'enlèvement (214) du polymère d'impression imprimé (304) est effectuée en utilisant un procédé d'arrachement.

11. Procédé selon la revendication 6, le procédé (200) comprenant en outre le dépôt d'une couche tampon (802) sur la couche d'absorption de lumière (102), la couche tampon (802) et la couche d'absorption de lumière (102) formant des parties d'une jonction pn disposée pour convertir la lumière en tension électrique.
